# EUROPEAN PATENT APPLICATION

(11) **EP 4 719 007 A1**
(43) Date of publication of application: **01.04.2026**
(21) Application number: 24832483.2
(22) Date of filing: 28.06.2024
(51) Int. Cl.: H10H 20/00, H10H 20/85, H10H 20/852, H01R 12/70, H10H 20/855

(54) **LIGHT EMITTING MODULE INCLUDING LIGHT EMITTING ELEMENT AND DISPLAY DEVICE USING SAME**

(30) Priority: 28.06.2023 US 202363523744 P; 27.06.2024 US 202418756352
(71) Applicant: Seoul Viosys Co., Ltd., Ansan-si, Gyeonggi-do 15429 (KR)
(72) Inventor: CHA, Namgoo, Ansan-Si Gyeonggi-do 15429 (KR)
(74) Representative: Stolmár & Partner Patentanwälte PartG mbB
(86) International application number: PCT/KR2024/009050
(87) International publication number: WO 2025/005706

(57) **Abstract**

A light emitting module according to an embodiment includes: a base plate; a light emitting device array substrate disposed on the base plate, and including a plurality of light emitting devices; a molding member covering the light emitting devices; a circuit board having one end electrically connected to the light emitting device array substrate; a connector electrically connected to an opposite end of the circuit board; and a reinforcement plate disposed under the connector.

## Description

### [Technical Field]

The present disclosure relates to a light emitting module including a light emitting device and a display apparatus using the same.

### [Background Art]

Light emitting devices are semiconductor devices that use light emitting diodes which are inorganic light sources, and have been used in various technical fields such as display apparatuses, vehicle lamps, and general lighting. The light emitting diodes have been quickly replacing conventional light sources because they have the advantages of long life, low power consumption, and fast response speed.

Conventionally, the light emitting devices have been mainly used as backlight sources in display apparatuses, but recently, display apparatuses that directly implement images using the light emitting devices haven been developed. A display apparatus that uses light emitting diodes (micro LEDs) with a lateral and vertical length of 100µm or less is also referred to as a micro LED display. Since the images are directly implemented using the light emitting devices, a thickness of the display apparatus may be dramatically reduced.

### [Disclosure]

### [Technical Problem]

Exemplary embodiments of the present disclosure provide a light emitting module suitable for a micro LED display and a display apparatus having the same.

Exemplary embodiments of the present disclosure provide a light emitting module including a light emitting device with improved light efficiency and a display apparatus having the same.

Exemplary embodiments of the present disclosure provide a light emitting module having improved heat dissipation characteristics and a display apparatus having the same.

### [Technical Solution]

According to an embodiment of the present disclosure, a light emitting module includes: a base plate; a light emitting device array substrate disposed on the base plate, and including a plurality of light emitting devices; a molding member covering the light emitting devices; a circuit board having one end electrically connected to the light emitting device array substrate; a connector electrically connected to an opposite end of the circuit board; and a reinforcement plate disposed under the connector.

The base plate may have a larger area than that of the light emitting device array substrate.

An upper surface of the base plate may be exposed near at least three side surfaces of the light emitting device array substrate.

A lateral width of the base plate and a lateral width of the reinforcement plate may be greater than a lateral width of the circuit board disposed between the base plate and the reinforcement plate. In addition, a longitudinal width of the base plate and a longitudinal width of the reinforcement plate may be greater than a longitudinal width of the circuit board disposed between the base plate and the reinforcement plate.

The light emitting device array substrate and the connector may be disposed on a same surface of the circuit board.

The light emitting device array substrate and the connector may be respectively disposed on different surfaces of the circuit board.

The light emitting module may include a window surrounded by the molding member.

The light emitting device array substrate may be mounted on the circuit board.

The connector may be formed on the circuit board.

The light emitting module may be disposed opposite to the connector, and may further include a cover covering a passive device or an active device.

According to an embodiment of the present disclosure, a display apparatus includes: a light emitting module; a lens assembly; and a light guide, wherein the light emitting module may include: a base plate; a light emitting device array substrate disposed on the base plate, and including a plurality of light emitting devices; a molding member covering the light emitting devices; a circuit board having one end electrically connected to the light emitting device array substrate; a connector electrically connected to an opposite end of the circuit board; and a reinforcement plate disposed under the connector.

The display apparatus may include a plurality of light emitting modules, and each of the emitting modules may emit light of a single color.

The light emitting module may be directly coupled to the lens assembly.

The display apparatus may further include a light coupler, and light emitting modules emitting light of different colors may be disposed on at least two surfaces of the light coupler.

Light emitting modules emitting green light, red light, and blue light may be disposed on each of three surfaces of the light coupler, and a light emitting module emitting green light may be disposed opposite to the lens assembly.

The base plate may have a larger area than that of the light emitting device array substrate.

The circuit board may be a flexible printed circuit board.

The light guide may include an automobile window or glass.

The display apparatus may form an image within the light guide.

The lens assembly may diffuse light.

### [Description of Drawings]

FIG. 1 is a schematic exploded perspective view illustrating a light emitting module according to a first embodiment of the present disclosure.
FIG. 2A is a schematic cross-sectional view illustrating the light emitting module according to the first embodiment of the present disclosure.
FIG. 2B is a schematic cross-sectional view enlarged from a portion of the light emitting module according to the first embodiment of the present disclosure.
FIG. 2C is a schematic plan view of FIG. 2B.
FIG 3 is a schematic cross-sectional view illustrating a light emitting module according to a second embodiment of the present disclosure.
FIG. 4 is a schematic cross-sectional view illustrating a light emitting module according to a third embodiment of the present disclosure.
FIG. 5 is a schematic cross-sectional view illustrating a light emitting module according to a fourth embodiment of the present disclosure.
FIG 6 is a schematic cross-sectional view illustrating a light emitting module according to a fifth embodiment of the present disclosure.
FIG 7 is a schematic rear view illustrating the light emitting module according to the fifth embodiment of the present disclosure.
FIG. 8 is a schematic exploded plan view illustrating a display apparatus having the light emitting module according to the fifth embodiment of the present disclosure.
FIG. 9 is a schematic plan illustrating a light emitting module according to a sixth embodiment of the present disclosure.
FIG 10 is a schematic side view illustrating a display apparatus having the light emitting module according to the sixth embodiment of the present disclosure.
FIG. 11 is a schematic plan view illustrating the display apparatus of FIG. 10.

### [Detailed Description of the Illustrated Embodiments]

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

A light emitting module of embodiments of the present disclosure may be applied to a display apparatus. In addition, a light emitting device included in the light emitting module may be a micro LED. A detailed description of the light emitting module is provided with reference to the drawings below.

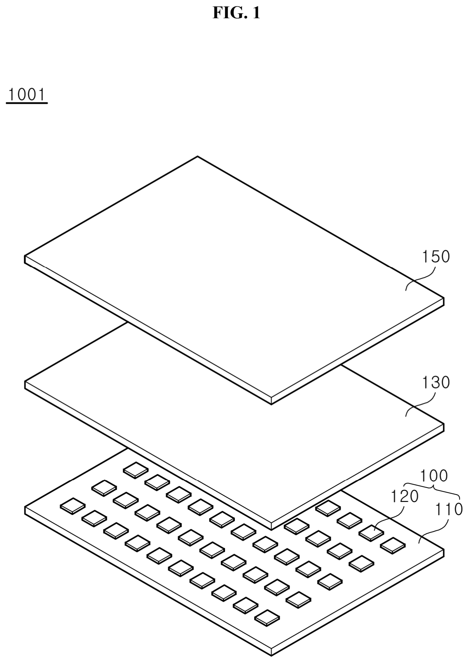

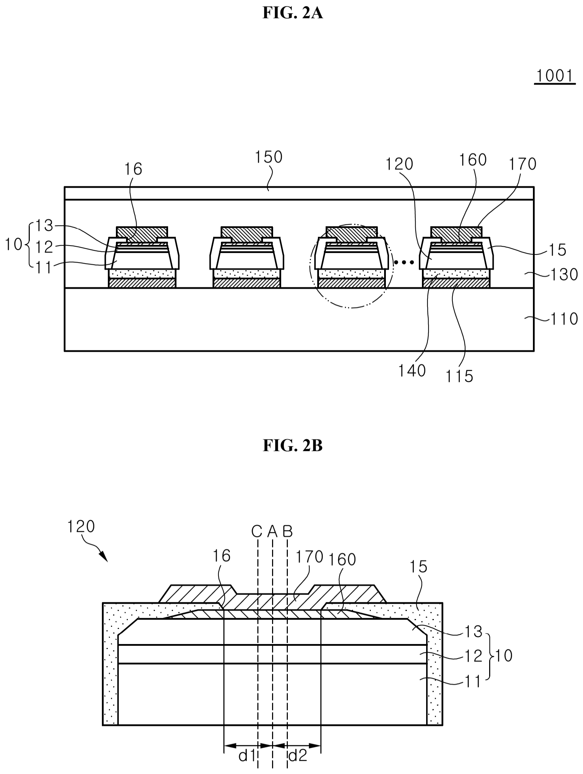

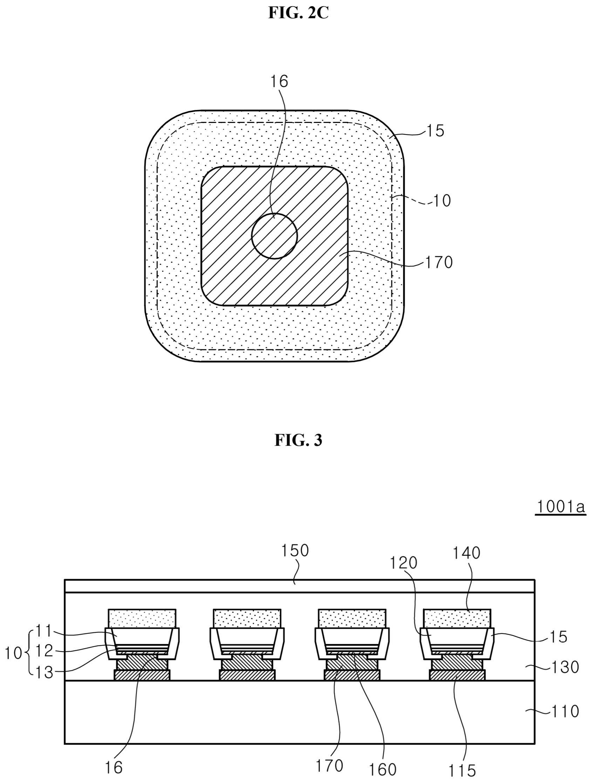

FIG. 1 is a schematic exploded perspective view illustrating a light emitting module 1001 according to a first embodiment of the present disclosure, FIG. 2A is a schematic cross-sectional view illustrating the light emitting module 1001 according to the first embodiment of the present disclosure, FIG. 2B is a schematic cross-sectional view enlarged to illustrate a portion of the light emitting module 1001 according to the first embodiment of the present disclosure, and FIG. 2C is a schematic plan view of FIG. 2B.

Referring to FIG. 1, FIG. 2A, FIG. 2B, and FIG. 2C, the light emitting module 1001 according to the first embodiment may include a circuit board 110, a plurality of light emitting devices 120, a first molding layer 130, and a second molding layer 150. The circuit board 110 having an array of the plurality of light emitting devices 120 is referred to as a light emitting device array board 100. The light emitting device 120 may include a first conductivity type semiconductor layer 11, an active layer 12, and a second conductivity type semiconductor layer 13. The light emitting module 1001 may include an insulation layer 15 and an electrode 17.

The circuit board 110 may include a circuit pattern that is an interconnection that supplies electricity to the light emitting device 120. When the light emitting devices 120 are mounted on the circuit board 110, they may be electrically connected to the circuit pattern. The electrodes of the light emitting devices 120 may be electrically connected by directly contacting the circuit pattern. Alternatively, the electrodes of the light emitting devices 120 may be electrically connected to the circuit pattern through a conductive adhesive material. For example, the circuit board 110 may be various types of printed circuit boards 110. However, the circuit board 110 is not limited to the printed circuit board 110, and may be anything as long as it has an interconnection for supplying electricity to the light emitting device 120.

The plurality of light emitting devices 120 may be electrically connected to one another on the circuit board 110 according to the circuit pattern such that they can be driven in series, parallel, or individually. According to this embodiment, the circuit pattern may be formed such that the plurality of light emitting devices 120 is operated independently. The light emitting devices 120 are light sources of the light emitting module 1001, and may be disposed on the circuit board 110. In addition, the light emitting devices 120 may be driven individually. According to this embodiment, the light emitting device 120 may be a light emitting diode in which an n-type semiconductor layer is disposed in a direction of a light exiting surface. Accordingly, when the plurality of light emitting devices 120 is included, all n-type electrodes may be disposed in a same direction. For example, the light emitting device 120 may include light emitting devices 120 that emit light having at least three different peak wavelengths from one another, such as red light, green light, and blue light.

The light emitting device 120 may have a light emitting structure 10 including a structure in which the first conductivity type semiconductor layer 11, the active layer 12, and the second conductivity type semiconductor layer 13 are stacked in that order. In addition, the first conductivity type semiconductor layer 11, the active layer 12, and the second conductivity type semiconductor layer 13 may be nitride semiconductor layers grown sequentially on a growth substrate. A type of light generated from the light emitting device 120 may vary depending on compositions of the first conductivity type semiconductor layer 11, the second conductivity type semiconductor layer 13, and the active layer 12. In this embodiment, it is exemplarily described that the first conductivity type semiconductor layer 11 is a p-type conductivity type semiconductor layer, and the second conductivity type semiconductor layer 13 is an n-type conductivity type semiconductor layer, but on the contrary, the first conductivity type semiconductor layer 11 may be an n-type conductivity type semiconductor layer, and the second conductivity type semiconductor layer 13 may be a p-type conductivity type semiconductor layer.

The active layer 12 may be formed between the first conductivity type semiconductor layer 11 and the second conductivity type semiconductor layer 13. The active layer 12 is a layer in which electrons injected through the first conductivity type semiconductor layer 11 and holes injected through the second conductivity type semiconductor layer 13 recombine, and light may be generated through the recombination of electrons and holes. Alternatively, the active layer 12 may generate light through the recombination of holes injected through the first conductivity type semiconductor layer 11 and electrons injected through the second conductivity type semiconductor layer 13.

The active layer 12 may be formed in any one of a single well structure, a multi-well structure, a single quantum well structure, a multi quantum well (MQW) structure, a quantum dot structure, or a quantum wire structure. In addition, the active layer 12 may include one material among InGaN, AlGaN, and GaN. However, the composition of the active layer 12 is not limited thereto.

In an embodiment, the first conductivity type semiconductor layer 11 may be formed of a compound semiconductor such as group III-V or group II-VI. The first conductivity type semiconductor layer 11 may be an n-type semiconductor layer doped with an n-type dopant. The second conductivity type semiconductor layer 13 may be formed of a compound semiconductor such as group III-V or group II-VI. The second conductivity type semiconductor layer 13 may be a p-type semiconductor layer doped with a p-type dopant. For example, the second conductivity type semiconductor layer 13 may be formed of AlGaN or GaN doped with a p-type dopant.

A conductive first electrode 140 is formed between the light emitting device 120 and the circuit board 110 and may be electrically connected to the electrode (a pad 115) formed on the circuit board 110. A conductive second electrode 160 may be formed over the light emitting device 120. The second electrode 160 may be formed to cover at least a portion of an upper surface of the second conductivity type semiconductor layer 13. The second electrode 160 may be electrically connected to the second conductivity type semiconductor layer 13 of the light emitting structure 10. The second electrode 160 may be formed of a light-reflecting material or a light-transmitting material. A position of an upper surface of the first electrode 140 disposed in at least one of the light emitting devices 120 may be different from that of an upper surface of the first electrode 140 disposed in another light emitting device 120 disposed adjacent thereto.

The light emitting device 120 in which the second electrode 160 is formed of the light-transmitting material may be applied to a light emitting module mounted on a transparent display apparatus. In the above case, the circuit board 110 of the light emitting module 1001 may also be formed of a light-transmitting material. In this case, when the light emitting module or display apparatus is powered off, the display apparatus may act like transparent glass. A thickness of the second electrode 160 may be different from that of the first electrode 140. By making the thickness of the second electrode 160 different from that of the first electrode 140, a transmittance of light transmitted to upper and lower portions may be adjusted. A width of the second electrode 160 may be different from that of the first electrode 140.

The insulation layer 15 may be formed over the second electrode 160. The insulation layer 15 may be formed to cover at least a partial region of the first electrode 160 and an upper surface and side surfaces of the light emitting device 120. The insulation layer 15 may be formed of SiO₂. The insulation layer 15 may include an opening 16 disposed over the light emitting structure 10. The opening 16 of the insulation layer 15 may be disposed over the second electrode 160. The opening 16 of the insulation layer 15 may be disposed on or near a central vertical line based on a width of the light emitting device 120. For example, a difference between a distance d1 to one side of a boundary of the opening 16 and a distance d2 to an opposite side based on a central axis of the opening 16 of the insulation layer 15 may be about 20% or less. Furthermore, the d1 and the d2 may be equal. In cross-section view, a virtual line A passing through a center of the opening 16 may be spaced apart from a virtual line B passing through a center of the second electrode 160. In cross-section view, the virtual line A passing through the center of the opening 16 may be spaced apart from a virtual line C passing through a center of the second conductivity type semiconductor layer 13. Accordingly, stress applied to the light emitting device 120 when a plurality of materials is stacked on the light emitting device 120 may be dispersed.

A conductive electrode 170 formed of a conductive material may be formed over the insulation layer 15. The conductive electrode 170 is formed to cover at least a portion of an upper surface of the insulation layer 15, and may be formed to contact the second electrode 160 through the opening 16 of the insulation layer 15. Accordingly, the conductive electrode 170 may be electrically connected to the second conductivity type semiconductor layer 13 of the light emitting device 120 through the second electrode 160. The conductive electrode 17 may be formed along a surface of the insulation layer 15 to have a concave structure in a region where the opening 16 of the insulation layer 15 is formed. A thickness of the insulation layer 15 may be smaller than that of the light emitting device 12. Accordingly, a loss of light emitted from the light emitting device 120 may be reduced.

It has been described that the second electrode 160 is disposed between the light emitting device 120 and the conductive electrode 170, but in other embodiments, the second electrode 160 may be omitted. Accordingly, the insulation layer 15 covers a portion of the light emitting device 120, and the conductive electrode 170 is formed, and thus, the conductive electrode 170 may be in contact with the light emitting device 120.

The light emitting device 120 may be a micro LED. That is, the light emitting device 120 may have a size in which a width and a length of its cross-sectional area are 100 µm or less, respectively. Furthermore, a size of the cross-sectional area of the light emitting device 120 may be 30 µm x 30 µm or less. Furthermore, the size of the cross-sectional area of the light emitting device 120 may be 10 µm x 10 µm or less.

The first molding layer 130 may be disposed over the circuit board 110 on which the light emitting device 120 is mounted. The first molding layer 130 covers the side surface of the light emitting device 120, when the plurality of light emitting devices 120 is mounted, the first molding layer 130 may be disposed between the plurality of light emitting devices 120, and further, it may be formed to surround the plurality of light emitting devices 120. The first molding layer 130 may cover a side surface of the first electrode 140 disposed between the light emitting device 120 and the substrate 110. Since the first molding layer 130 covers a boundary between the insulation layer 15 and the first electrode 140, the light emitting device 120 may be prevented from being peeled off from the first electrode 140. A width of the first molding layer 130 disposed between the light emitting device 120 and an adjacent light emitting device 120 may be greater than a thickness of the insulation layer 15 disposed on the side surface of the light emitting device 120.

The second molding layer 150 may be disposed over the first molding layer 130. The second molding layer 150 may be formed of a material different or a material having physical characteristics different from that of the first molding layer 130, and an interface may be formed between the second molding layer 150 and the first molding layer 130. However, the inventive concepts are not necessarily limited thereto, and they may have a form of one molding layer, the second molding layer 150 may be formed of a same material as that of the first molding layer 130, or may be formed without the interface between the second molding layer 150 and the first molding layer 130. The second molding layer 150 and the first molding layer 130 may be formed simultaneously in one process, or the second molding layer 150 may be formed after the first molding layer 130 is formed first. The second molding layer 150 includes a first surface in contact with the first molding layer 150 and a second surface disposed opposite to the first surface, and the second surface may include an anti-glare surface.

Furthermore, the second molding layer 150 may be formed of a material having a light absorption rate higher than that of the first molding layer 130. Accordingly, when light generated from the light emitting device 120 and emitted to the outside of the light emitting module 1001 is re-incident into the light emitting module 1001, a formation of an image such as a ghost may be prevented by absorbing light in the second molding layer 150. Meanwhile, a window may be formed within the second molding layer 150 to prevent light generated from the light emitting device 120 from being absorbed in the second molding layer 150. The window may be formed by partially removing the second molding layer 150, or by using a material having a light transmittance rate higher than that of the second molding layer 150.

The first conductivity type semiconductor layer 11 of the light emitting device 120 may have a flat surface, or may have a surface including irregularities. A width of the irregularities is formed within 5 µm to enable a stable connection with the electrode.

The light emitting device 120 may have a structure in which at least a portion thereof changes in width toward a direction of the upper portion. For example, regarding a width of the light emitting device 120, a width of the first conductivity type semiconductor layer 11 may be greater than that of the second conductivity type semiconductor layer 13. In the light emitting device 120, the upper surface or lower surface thereof and an inclined side surface connected thereto may form an obtuse angle. Accordingly, a phenomenon of current concentration at an edge of the light emitting device 120 may be alleviated compared to when the angle formed by the upper surface or lower surface of the light emitting device 120 and the side surface connected thereto is a right angle.

According to an embodiment, the plurality of light emitting devices 120 may be disposed in the light emitting module 1001, and light generated from the plurality of light emitting devices 120 is emitted through the second conductivity type semiconductor layer 13. A thickness of the second conductivity type semiconductor layer 13 may be smaller than that of the first conductivity type semiconductor layer 11, and light extraction efficiency may be improved by reducing absorption within the semiconductor layer along a path through which light generated in the active layer 12 is extracted to the outside. Preferably, the active layer 12 may be disposed above a center of the maximum thickness of the light emitting device 120. Since a distance from the active layer 12 where light is generated to an upper surface of the first molding layer 130 or to the interface between the first molding layer 130 and the second molding layer 150 may be shortened, light extraction may be increased, thereby improving an image clarity.

The light emitting device 120 has a structure in which at least a portion of the light emitting device 120 has a width that changes toward the upper portion or a light exiting direction. Preferably, a width of a conductivity type semiconductor layer disposed closer to the circuit board 110 may be larger than that of a conductivity type semiconductor layer disposed closer to the light exiting direction. The side surface of the light emitting device 120 may include an inclined side surface.

In cross section view, a width of the conductive electrode 170 may be about 80% or less of the width of the light emitting device 120. Accordingly, when light generated from the light emitting device 120 is emitted, it may be emitted to the outside without being interrupted by the conductive electrode 170.

In another embodiment, the first electrode 140 electrically connected to the plurality of light emitting devices 120 may serve as a common electrode. Alternatively, the first electrode 140 may be connected to a common electrode formed on the circuit board 110. Accordingly, an electrical signal may be simultaneously supplied to the first conductivity type semiconductor layers 11 of the plurality of light emitting devices 120 through the first electrode 140. In this case, the second electrode 160 or the conductive electrode 170 is disposed on each of the light emitting devices 120, and may be spaced apart from one another and also electrically apart from one another. The common electrode is disposed between the substrate 110 and the light emitting device 120, and the second electrode 160 or the conductive electrode 170, which is an individual electrode, is disposed between the light emitting device 120 and the first molding layer 130.

In another embodiment, the second electrode 160 or the conductive electrode 170 electrically connected to the plurality of light emitting devices 120 may serve as a common electrode. Accordingly, an electrical signal may be simultaneously supplied to the second conductivity type semiconductor layers 13 of the light emitting devices 120 through the second electrode 160 or the conductive electrode 170. Accordingly, light generated from each of the light emitting devices 120 may be emitted in a direction in which the common electrode is formed. When the second electrode 160 or the conductive electrode 170, which serves as the common electrode, includes a light-transmitting material, the second electrode 160 or the conductive electrode 170 may have light-transmittance for a plurality of wavelengths such that light of the plurality of wavelengths can be emitted through a light-transmitting common electrode. The first electrode 140 is disposed on each of the light emitting devices 120, and they may be spaced apart from one another and also electrically apart from one another.

FIG 3 is a schematic cross-sectional view illustrating a light emitting module 1001a according to a second embodiment of the present disclosure.

Referring to FIG. 3, the light emitting module 1001a according to this embodiment is generally similar to the light emitting module 1001 described with reference to FIG. 1, FIG. 2A, FIG. 2B, and FIG. 2C, except that light generated from a plurality of light emitting devices 120 is emitted through a first conductivity type semiconductor layer 11. A thickness of the first conductivity type semiconductor layer 11 may be greater than that of a second conductivity type semiconductor layer 13, and an active layer 12 may be disposed below a center of a maximum thickness of the light emitting device 120.

The light emitting device 120 has a structure in which at least a portion of the light emitting device 120 has a width that changes toward an upper portion or a light exiting direction. Preferably, a width of a conductivity type semiconductor layer disposed closer to a substrate 110 may be smaller than that of a conductivity type semiconductor layer disposed closer to the light exiting direction. Accordingly, the width of the light emitting device 120 in the light exiting direction is widened, and thus, a large amount of light may be emitted. The light emitting device 120 may include an inclined side surface. In cross section view, a width of a conductive electrode 170 may be about 80% or less of the width of the light emitting device 120. Accordingly, when light generated from the light emitting device 120 is emitted, it may be emitted to the outside without being interrupted by the conductive electrode 170.

In cross section view, a width of a first electrode 140 may be about 80% or less of the width of the light emitting device 120. Accordingly, when light generated from the light emitting device 120 is emitted, it may be emitted to the outside without being interrupted by the first electrode 140.

In another embodiment, the first electrode 140 electrically connected to the plurality of light emitting devices 120 may serve as a common electrode. Accordingly, an electrical signal may be simultaneously supplied to the first conductivity type semiconductor layers 11 of the plurality of light emitting devices 120 through the first electrode 140. Accordingly, light generated from each of the light emitting devices 120 may be emitted in a direction in which the common electrode is formed. In this case, a second electrode 160 or the conductive electrode 170 may be disposed on each of the plurality of light emitting devices 120, may be spaced apart from one another, and also electrically apart from one another. Accordingly, an individual electrode is disposed between the substrate 110 and the light emitting device 120, and the first electrode 140, which is the common electrode, is disposed between the light emitting device 120 and a first molding layer 130.

In another embodiment, the second electrode 160 or the conductive electrode 170 electrically connected to the plurality of light emitting devices 120 may serve as a common electrode. Accordingly, an electrical signal may be simultaneously supplied to the second conductivity type semiconductor layers 13 of the light emitting devices 120 through the second electrode 160 or the conductive electrode 170. The second electrode 160 or the conductive electrode 170 may have light-transmittance for a plurality of peak wavelengths, and may have reflectivity for the plurality of peak wavelengths. The first electrode 140 may be disposed on each of the plurality of light emitting devices 120, may be spaced apart from one another, and also electrically apart from one another.

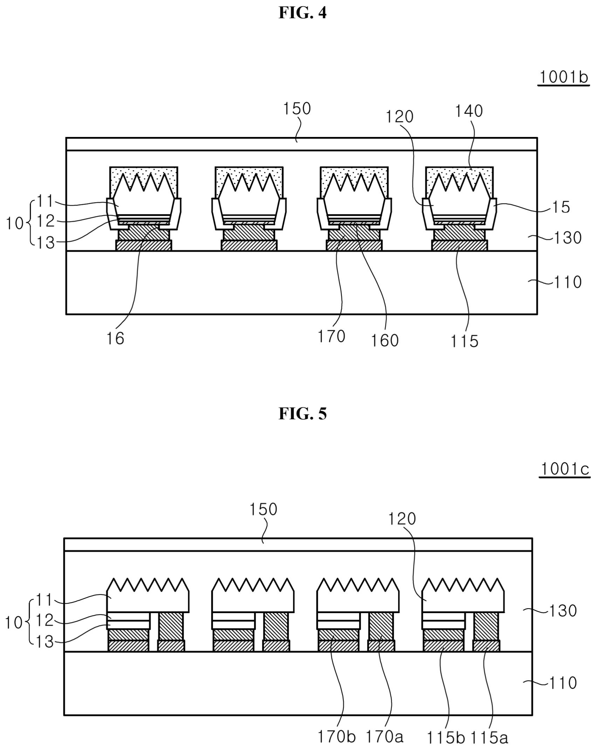

FIG 4 is a schematic cross-sectional view illustrating a light emitting module 1001b according to a third embodiment of the present disclosure.

Referring to FIG. 4, the light emitting module 1001b according to this embodiment is generally similar to the light emitting module 1001a described with reference to FIG. 3, except that irregularities are formed on a light extraction surface of a light emitting device 120. The irregularities may be formed within a region of a first conductivity type semiconductor layer 11 not to exceed a width of the first conductivity type semiconductor layer 11. An outermost surface of the irregularities may include an inclined surface, and an angle formed between the inclined surface of the irregularities and a side inclined surface of the semiconductor layer may be 90° or more or an obtuse angle.

A first electrode 140 may be formed along an irregularity surface, and a first molding layer 130 may fill a concave portion of the irregularity surface. However, the inventive concepts are not necessarily limited thereto, and the first electrode 140 may fill the concave portion of the irregularity to make an inclination of the irregularity gentle, thereby making a shape of the irregularity surface gentle at a boundary where the first molding layer 130 covers the light emitting device 120.

FIG. 5 is a schematic cross-sectional view illustrating a light emitting module 1001c according to a fourth embodiment of the present disclosure.

Referring to FIG. 5, the light emitting module 1000c according to this embodiment is generally similar to the light emitting modules 1001, 1001a, and 1001b described above, except that a light emitting device 120 has a flip-chip structure. That is, both a first electrode 170a and a second electrode 170b are disposed between the light emitting device 120 and a circuit board 110, and are flip-bonded to electrodes 115a and 115b of the circuit board 110. Instead of the second electrode 170b or in addition to the second electrode 170b, a conductive electrode may be formed.

Light emitted from the light emitting device 120 may be emitted through a first conductivity type semiconductor layer 11, and light efficiency may be improved because there is no electrode on a light exiting surface.

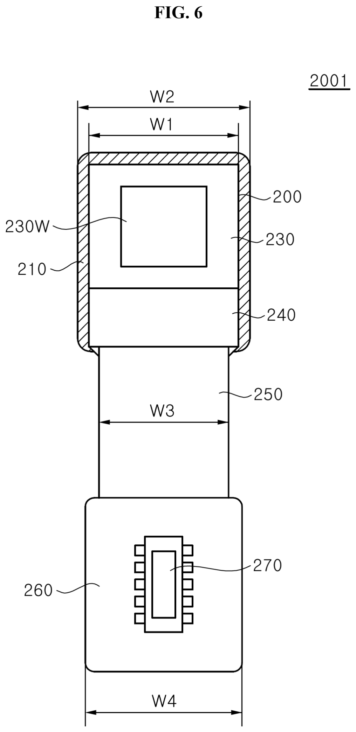

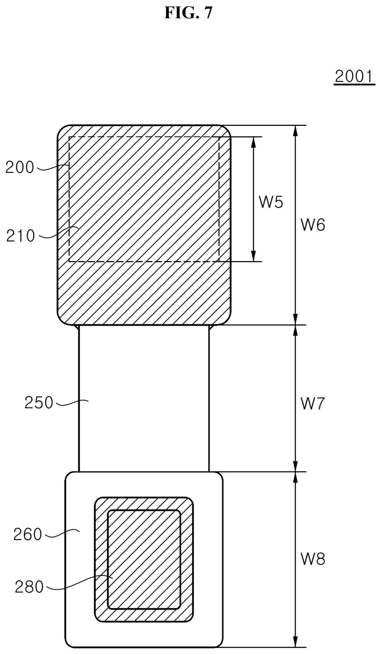

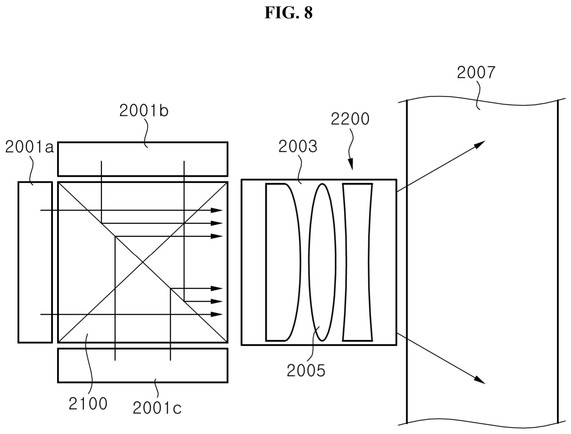

FIG. 6 is a schematic plan view illustrating a light emitting module 2001 according to a fifth embodiment of the present disclosure, FIG. 7 is a schematic rear view illustrating the light emitting module 2001 according to the fifth embodiment of the present disclosure, and FIG. 8 is a schematic exploded plan view illustrating a display apparatus having the light emitting module 2001 according to the fifth embodiment of the present disclosure.

First, referring to FIGs. 6 and 7, the light emitting module 2001 according to this embodiment may include a light emitting device array substrate 200, a base plate 210, a molding member 230, a window 230W, an extension portion 240, a circuit board 250, a reinforcement plate 260, a connector 270, and a cover 280.

The light emitting device array substrate 200 includes the circuit board and a light emitting device array disposed on the circuit board as described with reference to FIG. 1. In this embodiment, light emitting devices disposed on the light emitting device array substrate 200 may be light emitting devices that emit light of different wavelengths, or may be light emitting devices that emit light of a same color. In an embodiment, the light emitting devices arranged within the light emitting device array substrate 200 may be regularly arranged light emitting devices which emit red light, green light, and blue light, respectively. In another embodiment, the light emitting devices arranged within the light emitting device array substrate 200 may be light emitting devices which emit red light, green light, or blue light. In another embodiment, the light emitting devices arranged within the light emitting device array substrate 200 may be light emitting devices which emit green light and blue light, respectively.

The light emitting device array substrate 200 is disposed on the base plate 210. The base plate 210 may be formed of a material which is more solid than that of the circuit board 250, and for example, may be formed of metal. The base plate 210 may also be a thermally conductive material, and may assist a dissipation of heat generated in the light emitting device array substrate 200. The base plate 210 may have an area larger than that of the light emitting device array substrate 200 mounted thereon. For example, the light emitting device array substrate 200 may have a lateral width W1 and a longitudinal width W5, and the base plate 210 may have a lateral width W2 and a longitudinal width W6. The lateral width W2 and the longitudinal width W6 of the base plate 210 may be larger than the lateral width W1 and the longitudinal width W5 of the light emitting device array substrate 200, respectively. Moreover, as illustrated in FIG. 6, an upper surface of the base plate 210 may be exposed near at least three surfaces of the light emitting device array substrate 200. Accordingly, it is possible to prevent the array substrate 200 from being preferentially affected by external factors, and it may be effective in heat dissipation.

The light emitting device array substrate 200 may be covered with the molding member 230. The molding member 230 is formed of a material having a relatively high light absorption rate, and absorbs light incident from the outside. Meanwhile, the window 230W is surrounded by the molding member 230. The window 230W is a region where light generated from the light emitting device array substrate 200 is emitted. The window 230W may be formed of a material having a light transmittance rate higher than that of the molding member 230, or may be formed by at least partially removing the molding member 230. Meanwhile, another molding member having a light transmittance rate higher than that of the molding member 230 may be added between the molding member 230 and the light emitting device array substrate 200.

The circuit board 250 may be a flexible printed circuit board. The circuit board 250 has a circuit pattern. The circuit board 250 may be electrically connected to the light emitting device array substrate 200 disposed in the extension portion 240. For example, a circuit pattern in the light emitting device array substrate 200 and the circuit pattern in the circuit board 250 may be connected through bonding wires, and the extension portion 240 may be packaged for electrical safety. The extension portion 240 and the circuit board 250 may be physically connected, or may be electrically connected. In another embodiment, the circuit pattern in the light emitting device array substrate 200 and the circuit pattern in the circuit board 250 may be connected through a connecting socket. In another embodiment, the light emitting device array substrate 200 may be mounted on the circuit board 250.

One end of the circuit board 250 is connected to the light emitting device array board 200, and an opposite end is connected to the connector 270. The connector 270 may be electrically connected to the light emitting device array substrate 200, and may supply an electrical signal to the light emitting device array substrate 200. The connector 270 may be disposed on the reinforcement plate 260. The reinforcement plate 260 increases a strength of a region where the connector 270 is disposed, thereby assisting a connection between the connector and external components. The reinforcement plate 260 may also include a thermally conductive material. A marking capable of exposing information of the light emitting module 2001 may be provided on one surface of the circuit board 250. A lateral width of the circuit board 250 may be smaller than a longitudinal length. That is, the circuit board 250 is formed to have a longitudinal direction, and the light emitting device array board 200 and the connector 270 may be disposed along a longitudinal direction. Accordingly, a center of gravity of the light emitting module 2001 may be maintained. The connector 270 may include a power supply or driver IC.

A neck portion of the circuit board 250 positioned between the extension portion 240 and the reinforcement plate 260 has a lateral width W3 and a longitudinal width W7. The lateral width W3 of the circuit board 250 is smaller than the lateral width W2 of the base plate 210 and a lateral width W4 of the reinforcement plate 260. In addition, the longitudinal width W7 of the circuit board 250 is smaller than the longitudinal width W6 of the base plate 210 and a longitudinal width W8 of the reinforcement plate 260. Accordingly, an overall external size of the light emitting module 2001 may be reduced while maintaining its flexibility. The extension portion 240 and the reinforcement plate 260 may be symmetrical with the circuit board 250 as a center.

The extension portion 240, the circuit board 250 and the reinforcement plate 260 may be integrally formed.

The cover layer 280 may be disposed on an opposite surface of the reinforcement plate 260 opposite to the connector 270. The cover layer 280 protects various active or passive devices, such as resistors. An area of the cover layer 280 may be smaller than that of the base plate 210. Accordingly, when the light emitting module 2001 is installed in an apparatus such as a projector, it is possible to prevent that a weight is biased toward a position where the cover layer 280 is disposed so that the light emitting module 2001 is detached.

In this embodiment, the light emitting device array substrate 200 and the connector 270 are illustrated and described as being disposed on an upper surface side of the circuit board 250, and the base plate 210 and the cover layer 280 are disposed on a lower surface side of the circuit board 250, but the inventive concepts are not limited thereto. For example, the light emitting device array substrate 200 and the cover layer 280 may be disposed on the upper surface side of the circuit board 250, and the base plate 210 and the connector 270 may be disposed on the lower surface side of the circuit board 250.

Referring to FIG. 8, a display apparatus according to this embodiment may include a plurality of light emitting modules 2001a, 2001b, and 2001c, a light coupler 2100, a lens assembly 2200, and a light guide 2007.

The plurality of light emitting modules 2001a, 2001b, and 2001c is similar to the light emitting module 2001 described with reference to FIGs. 6 and 7, respectively, and may emit light of a single color. For example, the light emitting module 2001a may emit green light, the light emitting module 2001b may emit red light, and the light emitting module 2001c may emit blue light.

The light coupler 2100 couples light emitted from light emitting modules 2001a, 2001b, and 2001c. The light coupler 2100 may have, for example, a hexahedral shape, and the light emitting modules 2001a, 2001b, and 2001c may be disposed on each of three surfaces of the light coupler 2100.

Light emitted from the light emitting module 2001a is incident on the light coupler 2100 and thereafter, proceeds in an incident direction to pass through a light exiting surface of the light coupler 2100. Meanwhile, light incident on the light coupler 2100 from the light emitting module 2001b and the light emitting module 2001c is reflected from the inside and thereafter, passes through the light exiting surface of the light coupler 2100. Accordingly, light emitted from the light emitting modules 2001a, 2001b, and 2001c is coupled within the light coupler 2100. Meanwhile, by disposing the light emitting module 2001a emitting green light to be opposite to the lens assembly 2200, green light may pass through the light coupler 2100 without being reflected from the inside of the light coupler 2100. Accordingly, a loss of green light may be minimized, thereby making it more effective in reproducing color images.

The lens assembly 2200 may include a lens tube 2003 and lenses 2005. The lens tube 2003 secures positions of the lenses 2003 and protects the lenses 2005. Meanwhile, the lenses 2005 diffuse or converge light passing through the light coupler 2100. Various combinations of lenses may be used.

The light coupler 2100 may be disposed within a housing, and the lens assembly 2200 may be coupled to the housing. In addition, insertion holders are provided on three surfaces of the housing, and light emitting modules 2001a, 2001b, and 2001c may be coupled to the insertion holders. Moreover, a cover for covering the light emitting modules 2001a, 2001b, and 2001c may be coupled to the housing to protect the light emitting modules.

The light guide 2007 guides light incident through the lens assembly 2200 to form an image. The light guide 2007 may be, for example, a car window, augmented reality glasses, and the like. Accordingly, light emitted from the light emitting modules may form an image on the car window or glasses.

In this embodiment, an implementation of the color image using the three types of light emitting modules 2001a, 2001b, and 2001c is described, but the inventive concepts are not limited thereto. For example, one light emitting module may emit light of two colors, while each of other light emitting modules may emit light of one color. For example, the light emitting module 2001a may emit green light and blue light, and the light emitting modules 2001b and 2001c may emit red light. Accordingly, an intensity of red light may be relatively further increased. One of the light emitting modules 2001b and 2001c may be omitted.

In another embodiment, at least two connectors 270 among connectors 270 disposed in each of the modules 2001a, 2001b, and 2001c may be disposed to face each other. The connectors 270 disposed in each of the modules 2001a, 2001b, and 2001c may be disposed to face a center of the light coupler 2100. Accordingly, a distance between the connector 270 and the light coupler 2100 may be further narrowed.

In another embodiment, the light emitting module 2001a may emit green light and blue light, and the light emitting modules 2001b and 2001c may emit red light and green light, respectively. Accordingly, an intensity of green light may be relatively further increased.

In another embodiment, the light emitting module 2001a may emit blue light and red light, and the light emitting modules 2001b and 2001c may emit green light, respectively. Accordingly, the intensity of green light may be greatly increased. Moreover, a position of the light emitting module 2001a emitting two colors of light may also be varied.

In this embodiment, a micro lens array may be disposed between the light emitting modules 2001a, 2001b, and 2001c and the light coupler 2100. The micro lens array may also be formed within each light emitting module.

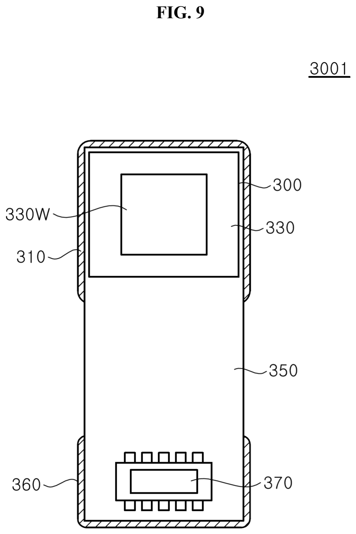

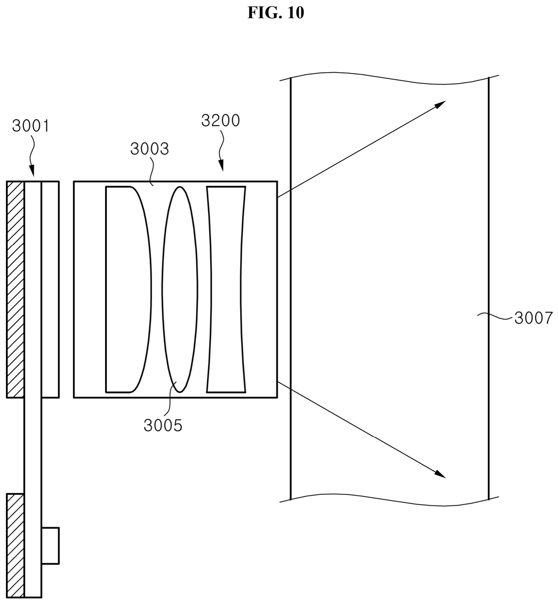

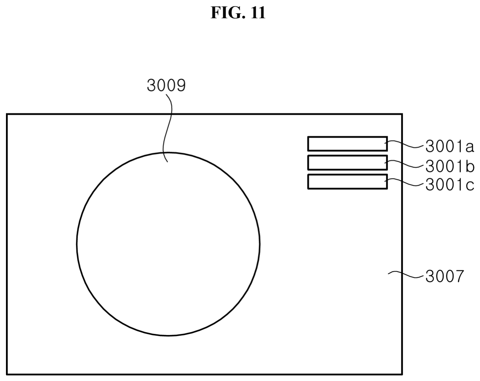

FIG. 9 is a schematic plan view illustrating a light emitting module 3001 according to a sixth embodiment of the present disclosure, FIG. 10 is a schematic side view illustrating a display apparatus having the light emitting module 3001 according to the sixth embodiment of the present disclosure, and FIG. 11 is a schematic plan view illustrating the display apparatus of FIG. 10.

First, referring to FIG. 9, the light emitting module 3001 according to this embodiment may include a light emitting device array substrate 300, a base plate 310, a molding member 330, a window 330, a circuit board 350, a reinforcement plate 360, and a connector 370.

Since the light emitting device array substrate 300, the molding member 330, and the window 330 are similar to the light emitting device array substrate 200, the molding member 230, and the window 230W described with reference to FIG. 6, respectively, a detailed description thereof is omitted to avoid redundancy.

The light emitting device array substrate 300 may be mounted on the circuit board 350, and the base plate 310 may be coupled to the circuit board 350 opposite to the light emitting device array substrate 300. The circuit board 350 may be a flexible printed circuit board, and the base plate 310 reinforces the flexibility of the circuit board 350. The base plate 310 may also be a heat dissipation plate.

One end of the circuit board 350 may be connected to the light emitting device array board 300, and an opposite end may be connected to the connector 370. The connector 370 is similar to the connector 270 described with reference to FIG. 6, except that the connector 370 is formed on the circuit board 350. The reinforcement plate 360 is disposed opposite to the connector 370, and the reinforcement plate 360 reinforces a strength of the circuit board 350.

In this embodiment, the base plate 310 and the reinforcement plate 360 are disposed on a lower surface side of the circuit board 350, and the light emitting device array substrate 300 and the connector 370 are disposed on an upper surface side of the circuit board 350. However, the inventive concepts are not necessarily limited thereto.

Meanwhile, in this embodiment, a lateral width of the base plate 310 or a lateral width of the reinforcement plate 360 may be larger than a lateral width of the circuit board 350, but the inventive concepts are not necessarily limited thereto, and they may be identical. Further, a lateral width of the light emitting device array substrate 330 may be smaller than the lateral width of the base plate 310, without being limited thereto, and may be identical.

Referring to FIG. 10, the display apparatus may include the light emitting modules 3001, a lens assembly 3200, and a light guide 3007.

The light emitting module 3001 is coupled to the lens assembly 3200 without using a light coupler. That is, the light emitting module 3001 may be directly coupled to the lens assembly 2200. The lens assembly 3200 includes a lens tube 3003 and lenses 3005 similar to the lens assembly 2200 described with reference to FIG. 8.

The light guide 3007 guides light incident through the lens assembly 2200 to form an image. The light guide 3007 may be, for example, a car window, augmented reality glasses, and the like. Accordingly, light emitted from the light emitting modules may form an image on the car window or glasses.

Referring to FIG. 11, light emitting modules 3001a, 3001b, and 3001c may be coupled to the light guide 3007. The light emitting modules 3001a, 3001b, and 3001c may emit red light, green light, and blue light, respectively. Three light emitting modules 3001a, 3001b, and 3001c are coupled to the light guide, and a color image may be formed in a specific region 3009 of the light guide by light emitted from these light emitting modules.

In this embodiment, it is described that an image is implemented using the three light emitting modules 3001a, 3001b, and 3001c, but the inventive concepts are not limited thereto. A display apparatus may also be provided in which a single light emitting module emitting light of a single color or light of two or more colors is coupled to the light guide. In another example, a light emitting module that emits two colors of light and a light emitting module that emits a single color of light, for example a light emitting module that emits green light and blue light and a light emitting module that emits red light, may be coupled to the light guide. In addition, a plurality of light emitting modules emitting light of a same color may be coupled to the light guide to increase an intensity of light of a particular color. For example, a light emitting module emitting green light or a light emitting module emitting red light may be added to the three light emitting modules described above.

Although various embodiments of the present disclosure have been described above, the present disclosure is not limited to the embodiments. In addition, matters or components described for an embodiment may be applied to other embodiments without departing from the technical spirit of the present disclosure.

## Claims

1. A light emitting module, comprising:
a base plate;
a light emitting device array substrate disposed on the base plate, and including a plurality of light emitting devices;
a molding member covering the light emitting devices;
a circuit board having one end electrically connected to the light emitting device array substrate;
a connector electrically connected to an opposite end of the circuit board; and
a reinforcement plate disposed under the connector.

2. The light emitting module of claim 1,
wherein the base plate has an area larger than that of the light emitting device array substrate.

3. The light emitting module of claim 2,
wherein an upper surface of the base plate is exposed near at least three side surfaces of the light emitting device array substrate.

4. The light emitting module of claim 2, wherein:
a lateral width of the base plate and a lateral width of the reinforcement plate are greater than a lateral width of the circuit board disposed between the base plate and the reinforcement plate, and
a longitudinal width of the base plate and a longitudinal width of the reinforcement plate are greater than a longitudinal width of the circuit board disposed between the base plate and the reinforcement plate.

5. The light emitting module of claim 1,
wherein the light emitting device array substrate and the connector are disposed on a same surface of the circuit board.

6. The light emitting module of claim 1,
wherein the light emitting device array substrate and the connector are respectively disposed on different surfaces of the circuit board.

7. The light emitting module of claim 1, comprising:
a window surrounded by the molding member.

8. The light emitting module of claim 1,
wherein the light emitting device array substrate is mounted on the circuit board.

9. The light emitting module of claim 1,
wherein the connector is formed on the circuit board.

10. The light emitting module of claim 1, further comprising:
a cover disposed opposite to the connector, and covering a passive device or an active device.

11. A display apparatus, comprising:
a light emitting module;
a lens assembly; and
a light guide,
the light emitting module, comprising:
a base plate;
a light emitting device array substrate disposed on the base plate, and including a plurality of light emitting devices;
a molding member covering the light emitting devices;
a circuit board having one end electrically connected to the light emitting device array substrate;
a connector electrically connected to an opposite end of the circuit board; and
a reinforcement plate disposed under the connector.

12. The display apparatus of claim 11, comprising:
a plurality of light emitting modules, each of the light emitting modules emitting light of a single color.

13. The light emitting module of claim 11,
wherein the light emitting module is directly coupled to the lens assembly.

14. The display apparatus of claim 11, further comprising:
a light coupler,
wherein light emitting modules emitting light of different colors are disposed on at least two surfaces of the light coupler.

15. The display apparatus of claim 14,
wherein light emitting modules emitting green light, red light, and blue light are disposed on each of three surfaces of the light coupler, and the light emitting module emitting green light is disposed opposite to the lens assembly.

16. The display apparatus of claim 11,
wherein the base plate has an area larger than that of the light emitting device array substrate.

17. The display apparatus of claim 11,
wherein the circuit board has a lateral width smaller than a longitudinal length.

18. The display apparatus of claim 11, further comprising:
a cover layer disposed on the reinforcement plate, wherein an area of the cover layer is smaller than that of the base plate.

19. The display apparatus of claim 18,
wherein an image is formed within the light guide.

20. The display apparatus of claim 11,
wherein the lens assembly diffuses light.
